# EUROPEAN PATENT APPLICATION

(11) **EP 4 033 618 A1**
(43) Date of publication of application: **27.07.2022**
(21) Application number: 21305083.4
(22) Date of filing: 22.01.2021
(51) Int. Cl.: H01S 5/00, H01S 5/026, H01S 5/042, G02F 1/225, G02B 6/12, H01S 5/22, H01S 5/343, H01S 5/12, H01S 5/125, H01S 5/40, H01S 5/14

(54) **MACH ZEHNDER-MODULATED LASERS**

(71) Applicant: Nokia Solutions and Networks Oy, 02610 Espoo (FI)
(72) Inventor: PARET, Jean Francois, 91290 Arpajon (FR); GARREAU, Alexandre, 92160 Antony (FR)
(74) Representative: Novagraaf Technologies

(57) **Abstract**

A high power Mach Zehnder-modulated laser (1) comprising:
• a set of n parallel lasers (2) comprising each a gain region and working in a continuous wave condition, said lasers (2) being arranged in such a way that the distance between the optical waveguides of two contiguous lasers (2)
• a first nx1 multi-mode interferometer MMI (3) with n inputs (30) and 1 output (31), for combining the optical input powers of said n lasers into one single global optical output power,
• a Mach-Zehnder interferometer (4), for modulating the global optical output power from said nx1 multi-mode interferometer MMI (3).

## Description

### TECHNICAL FIELD

Various example embodiments relate to high power modulated lasers. More particularly, various embodiments relate to high power Mach Zehnder-modulated lasers.

### BACKGROUND

As known by those skilled in the art, a Directly Modulated Laser (DML) is a single chip and provides a simple electrical circuit configuration for operation. It is implemented in compact designs, for low power and low cost applications.

In a DML, data is placed on the optical beam by modulating the injection current, which is an on-off electrical input signal. Performance of a DML degrades over distances of the order of 10 kilometres due to increased chromatic dispersion generated by modulation of the refractive index by the current injection. Its frequency response is also lower than 10 Gbit/s, and its extinction ratio is lower than that of an EML.

In addition, Electro-absorption Modulated Lasers (EML) is also known by those skilled in the art. An EML is a laser diode integrated with an electro-absorption modulator (EAM) in a single chip. It is applied to high-frequency telecommunications (up to 100 Gbit/s) and long-distance transmission (10 km to 100 km) applications, because of its low chromatic dispersion. The laser diode section operates under a continuous wave condition (CW), and on/off voltage input signals are applied to the EAM section to generate optical output signals. The properties of the laser are not altered by the modulation process. The frequency response up to 100 GHz of an EML depends on a capacitance in the EAM section. The extinction in an EML is generated by the voltage modulated absorption of the EAM section. Due to a lack of optical power, a semiconductor optical amplifier (SOA) should be typically added to the output of an EML to achieve higher optical power. A third electrode is then required to move the SOA away.

A drawback of EMLs is the balance between the laser's emission power and the ability of the EAM to modulate this optical power. Indeed, the more optical power the laser emits, the longer the cross-section of the EAM is to absorb the increased optical power with the same extinction ratio and voltage control.

### SUMMARY

Example embodiments of the invention aim to remedy all or some of the disadvantages of the above identified prior art.

The embodiments and features, if any, described in this specification that do not fall under the scope of the independent claims are to be interpreted as examples useful for understanding various embodiments of the invention.

A general embodiment relates an apparatus comprising:
- a set of n parallel lasers (defining an active zone of the apparatus), each laser from the set of n parallel lasers comprising a gain region and being configured for working in a continuous wave condition, said lasers being arranged in such a way that the distance between the optical waveguides of two contiguous lasers is higher than 5 µm,
- a first nx1 multi-mode interferometer MMI (defining the passive zone of the apparatus) with n inputs and 1 output, for combining the optical input powers of said n lasers into an optical output power (in other words , the n inputs of the first MMI being coupled with each optical waveguides of the n laser) and
- a Mach-Zehnder interferometer (defining an active zone of the apparatus), for modulating the optical output power from said nx1 multi-mode interferometer MMI), in order to reach high frequencies without a limitation of optical power.

The Mach-Zehnder interferometer may be remotely controlled by a single electrode.

The distance (or pitch) between the optical waveguides of two contiguous lasers corresponds to the minimum distance without interaction between the two optical modes confined in the optical waveguides of two contiguous lasers. The pitch between the optical waveguides of two contiguous lasers may preferably be the lowest in order to limit the length of the MMI. It is well known that the width and length of the MMI are proportional.

If the apparatus only had one laser, the gain peak would shift to the longer wavelengths, thus requiring a balance between gain peak, Bragg grating wavelength and temperature. An optical SOA amplifier would then be required to achieve higher optical power.

If the apparatus has n lasers disposed in accordance with the general embodiment of the apparatus, the overall optical power is equal to n times the power of each laser and the photon/electron quantum efficiency is better; there will be less heating and more power will be obtained with less stress on this gain-wavelength-temperature balance. This eliminates the need for an SOA optical amplifier.

Advantageously, the gain region of said n parallel lasers may be either a multiple quantum well (usually referred to by the acronym MQW) optical waveguide or a quantum dot.

Specific features or embodiments of the apparatus, usable alone or in combination (provided that there is no conflict between the different elements) may be as follows:
- use of butt-joints for coupling each optical waveguide of the n lasers with a respective input of a nx1 multi-mode interferometer MMI, and for coupling the output of the nx1 multi-mode interferometer MMI and the Mach-Zehnder interferometer (as detailed hereinafter),
- only two electrodes may be needed,
- use of silicon photonic or optical dielectric waveguides.

The selection of the wavelength may be realized by Distributed Feed-Back grating (DFB) or distributed Bragg Reflector (DBR).

Then, according to a first example of the general embodiment, the n parallel lasers may be distributed in a Feedback grating configuration.

If the selection of the wavelength is realized by Distributed Feed-Back grating (DFB), the apparatus is more compact and there will be less optical losses. Advantageously, the apparatus according to this first configuration may further comprise:
- a first optical butt-joint coupling each optical waveguide of the n lasers with a respective input of the first nx1 multi-mode interferometer MMI, and
- a second optical butt-joint coupling the output of the nx1 multi-mode interferometer MMI and the Mach-Zehnder interferometer.

According to a second example of the general embodiment, the apparatus may further comprise:
- a second nx1 multi-mode interferometer MMI with n inputs and 1 output (in other words, the n inputs of the second MMI being coupled with each optical waveguides of the n lasers),
- a first distributed Bragg reflector (DBR) being placed downstream of said first nx1 multi-mode interferometer MMI, and
- a second distributed Bragg reflector (DBR) being placed upstream of said second nx1 multi-mode interferometer MMI.

If the selection of the wavelength is realized by Distributed Bragg Reflector (DBR), it will be possible to reach a high spectral purity (fineness of ray linewidth), with less parasitic effects. This high spectral purity prevents wavelength spreading on long-distance transmission, and this lowers the Bit ERROR RATE (DER) error rate.

Advantageously, the apparatus according to this second configuration may further comprise:
- a first optical butt-joint coupling each optical waveguide of the n lasers with a respective input of the first nx1 multi-mode interferometer MMI,
- a second optical butt-joint coupling the output of the first nx1 multi-mode interferometer MMI and the Mach-Zehnder interferometer, and
- a third optical butt-joint coupling each optical waveguide of the n lasers with a respective input of the second nx1 multi-mode interferometer MMI.

Different technologies are available for the realisation of the device, based on either ridge or buried structures. The main differentiation lies in the passive region, corresponding to the nx1 multi-mode interferometers MMI.

In particular, according to a first specific embodiment:
- the optical waveguides of the n lasers, the inputs and the output of the first nx1 multi-mode interferometer MMI and, if applicable, the inputs and the output of the second nx1 multi-mode interferometer MMI are made of III-V semiconductors,
- the first nx1 multi-mode interferometer MMI and, if applicable, the second nx1 multi-mode interferometer MMI, comprise a gain region with a gap energy higher than that of the gain region of the n lasers.

Advantageously, in this first specific embodiment, the pitch (or distance) between the optical waveguides of two contiguous lasers may be comprised between 5 and 10 µm. The advantage of this small pitch is that the lasers can be powered with only one electrode.

The Mach-Zehnder interferometer and the lasers are patterned in the same epitaxial structure in order to interact with the light by modulation or by light production. The MMI is patterned in a more transparent region. For example, in the case of 1.55 µm optical wavelength generated in the gain region (for instance MQW) of the lasers, the photoluminescence of the optical waveguides of the passive region may be around 1300 µm.

According to a second specific embodiment,
- the optical waveguides of the n lasers may be made of III-V semiconductors,
- the inputs and the output of the first nx1 multi-mode interferometer MMI and, if applicable, the inputs (80) and the output of the second nx1 multi-mode interferometer MMI may be made of a dielectric that is embedded in an encapsulation material, the optical index of which is higher than the optical index of the dielectric,

Advantageously, in this second specific embodiment, the pitch (or distance) between the optical waveguides of two contiguous lasers may be comprised between 5 and 20 µm. The advantage of this small pitch is that the lasers can be powered with only one electrode.

For these first and second specific embodiments, each of the n lasers may have a wafer structure comprising a substrate and an upper layer (201), wherein said upper layer is a shallow ridge or deep ridge structure, or a deep buried structure, on which a metal is disposed.

For the first and second specific embodiments, the apparatus may comprise another metal contact that is disposed under the substrate.

For these first and second specific embodiments, when the upper layer presents a shallow ridge structure or a deep ridge structure, said upper layer may be made of a material chosen among the group consisting of silica, nitride, oxynitride, polymers, organic resin (for instance PCB or polyimide).

For these first and second specific embodiments, when the upper layer presents a deep buried structure, said upper layer may be made of a semiconductor having a Buried Ridge Structure (BRS), a Semi Insulating Buried Heterostructure (SiBH), or a pn Buried Heterostructure (pnBH).

A third specific embodiment is based on silicon photonics. Then the apparatus according to this third specific embodiment comprises the following features:
- the optical waveguides of the n lasers may be III-V semiconductors that are integrated on a Silicon-On-Insulator (SOI) wafer, and the n lasers (2) may be patterned in an epitaxial III-V structure, in order to interact with the light by modulation or by light production,
- the inputs and the output of the nx1 multi-mode interferometer MMI and the optical waveguides of the Mach-Zehnder interferometer may be optical waveguides made of silicon nitride (for instance Si₃N₄ or SiON),
- the nx1 multi-mode interferometer MMI (3) and the Mach-Zehnder interferometer (4) may be patterned in the same SiO₂ structure.

Advantageously, in this third specific embodiment, the pitch (or distance) between the optical waveguides of two contiguous lasers may be comprised between 5 and 20 µm. The advantage of this small pitch is that the lasers can be powered with only one electrode.
In this third specific embodiment, the laser region integration on the silicon on insulator (SOI) wafer can be monolithic or heterogeneous. Monolithic approaches involve the direct hetero-epitaxy of laser materials on silicon. Heterogeneous approaches involve the intimate merging of traditionally incompatible materials and their subsequent co-fabrication to form devices. The bottom contact is preferably not to be used due to a resistance between the silicon substrate and the III-V epitaxy. The via and contact on the upper surface may be used.

### BRIEF DESCRIPTION OF THE DRAWINGS

Some example embodiments are now described, by way of example only, and with reference to the accompanying drawings in which:

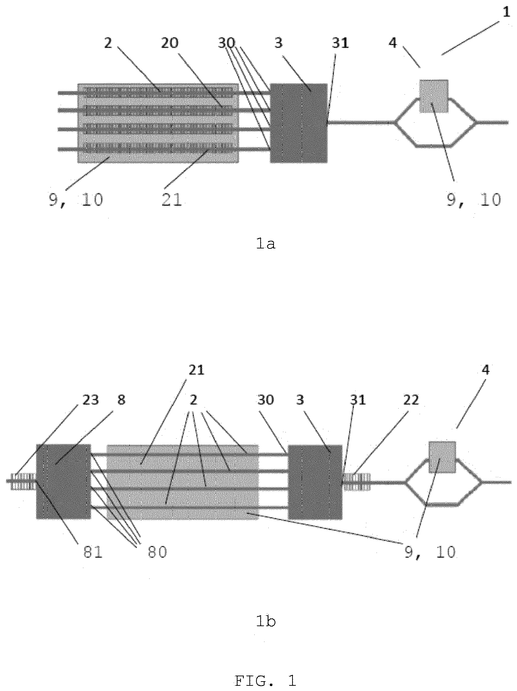

- FIG. 1 schematically represents a top view of the apparatus according to a first configuration where the selection of the wavelength is realized by Distributed Feed-Back grating DFB (see schema 1a) and according to a second configuration where the selection of the wavelength is realized by distributed Bragg Reflector DBR (see schema 1b);

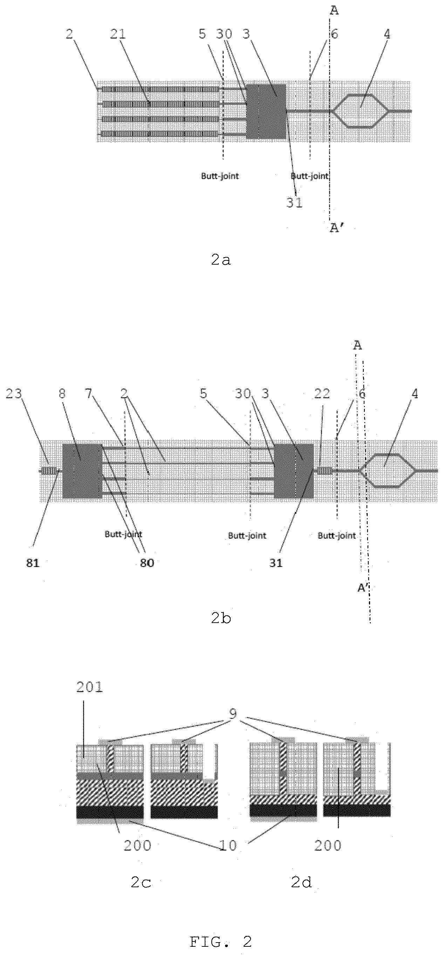

- FIGs. 2a to 2d schematically represent a first specific embodiment of the apparatus comprising two top views of this embodiment according to two configurations (DFB in figure 2a and DBR in figure 2b) and four sectional views showing different structures of the wafer structure of a laser (figures 2c and 2d);

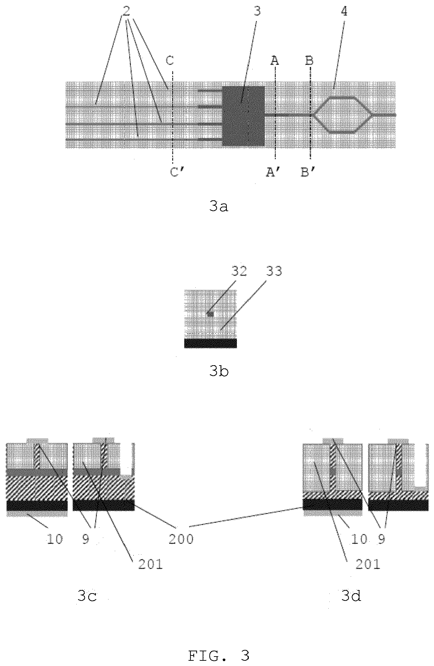

- FIGs. 3a to 3d schematically represent a second specific embodiment of the apparatus comprising one top view of this embodiment (figure 3a), one sectional view of the passive zone (figure 3b) and four sectional views showing different structures of the wafer structure of a laser (figures 3c and 3d) ;

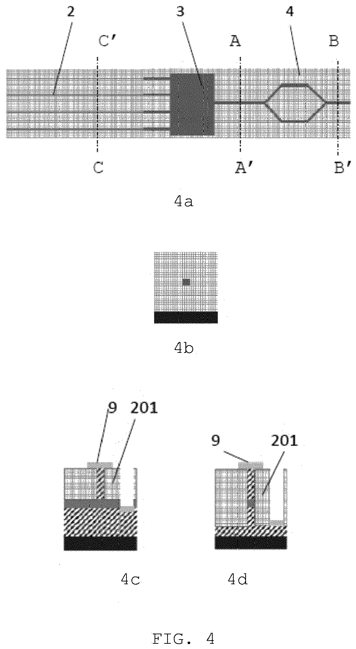

- FIGs. 4a to 4d schematically represent a third specific embodiment of the apparatus comprising one top view of this embodiment (figure 3a), one sectional view of the passive zone (figure 3b) and two sectional views showing different structures of the wafer structure of a laser (figures 4c and 3d) .

The same reference number represents the same element or the same type of element on all drawings, unless stated otherwise.

### DETAILLED DESCRIPTION

The figures and the following description illustrate specific exemplary embodiments of the invention. It will thus be appreciated that those skilled in the art will be able to devise various arrangements that, although not explicitly described or shown herein, embody the principles of the invention and are included within the scope of the invention. Furthermore, any examples described herein are intended to aid in understanding the principles of the invention, and are to be construed as being without limitation to such specifically recited examples and conditions. As a result, the invention is not limited to the specific embodiments or examples described below, but by the claims and their equivalents.

In the following description, well-known functions or constructions by the man skilled in the art are not described in detail since they might obscure the invention in unnecessary detail.

In the following description of the figures, schematic representations are non-limiting and serve only for the understanding of the invention.

FIGs. 1a and 1b schematically represent two different configurations that illustrate two different modes of wavelength selection, either by Distributed Feed-Back grating DFB (see schema 1a) or by distributed Bragg Reflector DBR (see schema 1b). In particular FIG. 1a shows an apparatus according to a first configuration comprising:
- a set of n parallel lasers 2, a first nx1 multi-mode interferometer MMI 3 with n inputs 30 and 1 output 31, for combining the optical input powers of said n lasers into an optical output power, the n parallel lasers 2 being distributed in a Feedback DFB grating 21 configuration,
- a first nx1 multi-mode interferometer MMI 3 with n inputs 30 and 1 output 31, for combining the optical input powers of said n lasers into an optical output power, and
- a Mach-Zehnder interferometer 4, for modulating the combined optical output power from said nx1 multi-mode interferometer MMI 3.

FIG. 1b shows an apparatus according to a second configuration of Figure 1b which differs from Figure 1a in that it also comprises:
- a second nx1 multi-mode interferometer MMI 8 with n inputs 80 and 1 output 81,
- a first distributed Bragg reflector DBR 22 being placed downstream of said first nx1 multi-mode interferometer MMI 3, and
- a second distributed Bragg reflector DBR 23 being placed upstream of said second nx1 multi-mode interferometer MMI 8.

FIG. 2a to FIG. 2d illustrate a first specific embodiment of the apparatus.

In FIG. 2a, the selection of the wavelength is realized by Distributed Feed-Back grating DFB. A first optical butt-joint 5 is coupling each optical waveguide of the n lasers with a respective input 30 of the first nx1 multi-mode interferometer MMI 3, and a second optical butt-joint 6 is coupling the output 31 of the nx1 multi-mode interferometer MMI 3 and the Mach-Zehnder interferometer 4.

In FIG. 2b, the selection of the wavelength is realized by distributed Bragg Reflector DBR. A first optical butt-joint 5 is coupling each optical waveguide of the n lasers 2 with a respective input 30 of the first nx1 multi-mode interferometer MMI 3, and a second optical butt-joint 6 is coupling the output 31 of the first nx1 multi-mode interferometer MMI 3 and the Mach-Zehnder interferometer 4. Furthermore, there is also a third optical butt-joint 7 coupling each optical waveguide of the n lasers with a respective input 80 of the second nx1 multi-mode interferometer MMI (8).

FIG. 2c and 2d are sectional views showing different structures of the wafer structure of a laser 2 from the set of n lasers.

In FIG. 2c, the lasers 2 have a wafer structure comprising a substrate 200 and an upper layer 201 presenting a shallow ridge structure. On the right hand side of figure 2c, one metal contact 9 is disposed on the upper layer 201. On the left hand side of figure 2c, another metal contact 10 is disposed under the substrate (200) .

In FIG. 2d, the lasers 2 have a wafer structure comprising a substrate 200 and an upper layer 201 presenting a deep ridge or buried structure. On the right hand side of figure 2d, one metal contact 9 is disposed on the upper layer 201. On the left hand side of figure 2d, another metal contact 10 is disposed under the substrate (200).

FIG 3a to 3d illustrate a second specific embodiment of the apparatus.

In FIG. 3a, the optical waveguides of the n lasers 2 are made of III-V semiconductors, whereas the passive region (of the MMI 3) is a dielectric passive region, schematically illustrated by FIG. 3b.

FIG. 3b is a sectional view showing the structure of the optical waveguides constituting the inputs 30 and the output 31 of the nx1 multi-mode interferometer MMI 3 (and, if applicable, of the inputs 80 and the output 81 of the second nx1 multi-mode interferometer MMI 8). These optical waveguides are made of a dielectric 32 (for instance Si₃N₄) that is embedded in an encapsulation material 33 (for instance SiO₂), the optical index of which is higher than the optical index of the dielectric.

FIG. 3c and 3d are sectional views showing different structures of the wafer structure of a laser 2 from the set of n lasers. These figures are similar to FIG. 2c and 2d respectively, in the sense that the wafer structure of the lasers n are similar as those of the first specific embodiment shown in figure 2.

FIG 4a to 4d illustrate a third specific embodiment of the apparatus.

FIG. 4a shows that the n lasers 2 are patterned in an epitaxial III-V structure, and the nx1 multi-mode interferometer MMI (3) and the Mach-Zehnder interferometer 4 are patterned in the same SiO₂ structure.

FIG. 4b is a sectional view showing the structure of the optical waveguides constituting the inputs 30 and the output 31 of the nx1 multi-mode interferometer MMI 3, and also of those of the Mach-Zehnder interferometer 4. These optical waveguides are made of a dielectric 32 (for instance Si₃N₄) that is embedded in an encapsulation material 33 (for instance SiO₂), the optical index of which is higher than the optical index of the dielectric.

FIG. 4c and 4d are sectional views showing different structures of the wafer structure of a laser 2 from the set of n lasers. These figures show identical wafer structures to the right hand sides of FIG. 2c and 2d respectively, with the difference that the optical waveguides of the n lasers 2 are III-V semiconductors that are integrated on a Silicon-On-Insulator (SOI) wafer.

The apparatus as described in the embodiments described above has n lasers. Therefore, the overall optical power is equal to n times the power of each laser and the photon/electron quantum efficiency is better. Furthermore, there will be less heating and more power will be obtained with less stress on the gain-wavelength-temperature balance. This, as previously mentioned, eliminates the need for an SOA optical amplifier, while providing a high power Mach-Zehnder modulated laser.

## Claims

1. An apparatus (1) comprising:
• a set of n parallel lasers (2), each laser (2) from the set of n parallel lasers comprising a gain region and being configured for working in a continuous wave condition, said lasers (2) being arranged in such a way that the distance between the optical waveguides of two contiguous lasers (2) is higher than 5 µm,
• a first nx1 multi-mode interferometer MMI (3) with n inputs (30) and 1 output (31), for combining the optical input powers of said n lasers into an optical output power,
• a Mach-Zehnder interferometer (4), for modulating the optical output power from said nx1 multi-mode interferometer MMI (3).

2. The apparatus (1) according to claim 1, wherein each respective gain region of said n parallel lasers (2) is either a multiple quantum well optical waveguide or a quantum dot.

3. The apparatus (1) according to any of claims 1 or 2, wherein the n parallel lasers (2) are distributed in a Feedback (DFB) grating (21) configuration.

4. The apparatus (1) according to any of claims 1 or 2, further comprising:
- a second nx1 multi-mode interferometer MMI (8) with n inputs (80) and 1 output (81),
- a first distributed Bragg reflector (DBR) (22) being placed downstream of said first nx1 multi-mode interferometer MMI (3), and
- a second distributed Bragg reflector (DBR) (23) being placed upstream of said second nx1 multi-mode interferometer MMI (8) .

5. The apparatus (1) according to claim 3, further comprising:
• a first optical butt-joint (5) coupling each optical waveguide of the n lasers with a respective input (30) of the first nx1 multi-mode interferometer MMI (3), and
• a second optical butt-joint (6) coupling the output (31) of the nx1 multi-mode interferometer MMI (3) and the Mach-Zehnder interferometer (4).

6. The apparatus (1) according to claim 4, further comprising:
• a first optical butt-joint (5) coupling each optical waveguide of the n lasers (2) with a respective input (30) of the first nx1 multi-mode interferometer MMI (3),
• a second optical butt-joint (6) coupling the output (31) of the first nx1 multi-mode interferometer MMI (3) and the Mach-Zehnder interferometer (4), and
• a third optical butt-joint (7) coupling each optical waveguide of the n lasers with a respective input (80) of the second nx1 multi-mode interferometer MMI (8).

7. The apparatus (1) according to any of claims 5 or 6, wherein:
• the optical waveguides of the n lasers (2), the inputs (30) and the output (31) of the first nx1 multi-mode interferometer MMI (3) and, if present, the inputs (80) and the output (81) of the second nx1 multi-mode interferometer MMI (8) are made of III-V semiconductors,
• the first nx1 multi-mode interferometer MMI (3) and, if present, the second nx1 multi-mode interferometer MMI (8), comprise a gain region with a gap energy higher than that of the gain region of the n lasers.

8. The apparatus (1) according to any of claims 5 or 6, wherein:
• the optical waveguides of the n lasers (2) are made of III-V semiconductors,
• the inputs (30) and the output (31) of the first nx1 multi-mode interferometer MMI (3) and, if present, the inputs (80) and the output (81) of the second nx1 multi-mode interferometer MMI (8) are made of a dielectric (32) that is embedded in an encapsulation material (33), the optical index of which is higher than the optical index of the dielectric.

9. The apparatus (1) according to any of claims 7 or 8, wherein each of the n lasers (2) has a wafer structure comprising a substrate (200) and an upper layer (201), said upper layer (201) presenting a shallow ridge structure, on which a metal contact (9) is disposed.

10. The apparatus (1) according to any of claims 7 or 8, wherein each of the n lasers (2) has a wafer structure comprising a substrate (200) and an upper layer (201), said upper layer (201) presenting a deep ridge structure on which a metal contact (9) is disposed.

11. The apparatus (1) according to any of claims 7 or 8, wherein each of the n lasers (2) has a wafer structure comprising a substrate (200) and an upper layer (201), said upper layer (201) presenting a deep buried structure on which a metal contact (9) is disposed.

12. The apparatus (1) according to any of claims 9 to 11, further comprising a metal contact (10) disposed under the substrate (200).

13. The apparatus (1) according to any of claims 9 or 10, wherein said upper layer (201) is made of a material chosen among the group consisting of silica, nitride, oxynitride, polymers, organic resin.

14. The apparatus (1) according to claim 11, wherein said upper layer (201) is made of a semiconductor having a Buried Ridge Structure (BRS), a Semi Insulating Buried Heterostructure (SiBH), or a pn Buried Heterostructure (pnBH).

15. The apparatus (1) according to claim 1, wherein:
• the respective optical waveguides of the n lasers (2) are III-V semiconductors that are integrated on a Silicon-On-Insulator (SOI) wafer, and the n lasers (2) are patterned in an epitaxial III-V structure ,
• wherein the inputs (30) and the output (31) of the nx1 multi-mode interferometer MMI (3) and the optical waveguides of the Mach-Zehnder interferometer (4) are optical waveguides made of silicon nitride,
• wherein the nx1 multi-mode interferometer MMI (3) and the Mach-Zehnder interferometer (4) are patterned in the same SiO₂ structure.
